# EUROPÄISCHE PATENTANMELDUNG

(11) **EP 2 373 144 A1**
(43) Veröffentlichungstag der Anmeldung: **05.10.2011**
(21) Anmeldenummer: 11002395.9
(22) Anmeldetag: 23.03.2011
(51) Int. Cl.: H05K 13/00

(54) **Vorrichtung zum Bearbeiten von Werkstücken**

(30) Priorität: 31.03.2010 DE 102010013506
(71) Anmelder: Mimot GmbH, 79541 Lörrach (DE)
(72) Erfinder: Pfeil, Stephan, 79585 Steinen (DE)
(74) Vertreter: Dimmerling & Huwer

(57) **Zusammenfassung**

Eine Vorrichtung zum Bearbeiten von Werkstücken (10), insbesondere zum Bestücken von Leiterplatten, mit wenigstens zwei Bearbeitungsstationen (1, 2), in welche die Werkstücke (10) einbringbar sind, die auf einem Transportweg, auf dem die Werkstücke (10) regulär durch die Vorrichtung transportiert werden, hintereinander angeordnet sind, ist dadurch gekennzeichnet, dass wenigstens ein erstes Bypasselement (3) vorhanden ist, welches außerhalb des regulären Transportweges der Werkstücke (10) angeordnet ist, und mittels dem die Werkstücke (10) wenigstens an der ersten Bearbeitungsstation (1) vorbeiführbar sind.

## Beschreibung

Die Erfindung betrifft eine Vorrichtung zum Bearbeiten von Werkstücken, insbesondere zum Bestücken von Leiterplatten, mit wenigstens zwei Bearbeitungsstationen, in welche die Werkstücke einbringbar sind, die auf einem Transportweg, auf dem die Werkstücke regulär durch die Vorrichtung transportiert werden, hintereinander angeordnet sind.

Eine derartige Vorrichtung ist im Stand der Technik hinreichend bekannt und wird beispielsweise zur Montage von Geräten, welche eine Vielzahl von Einzelteilen aufweisen, oder zur Bestückung von Leiterplatten mit elektronischen Bauelementen verwendet.

Unter dem Transportweg, auf dem die Werkstücke regulär durch die Vorrichtung transportiert werden, wird der Weg verstanden, den die Werkstücke bei ordnungsgemäßem Betrieb der Vorrichtung von ihrer Eingabe in die Vorrichtung bis zu ihrer Ausgabe aus der Vorrichtung in der Vorrichtung zurück legen. Dies ist in der Regel ein linearer Weg, der nicht verlassen werden kann.

In jeder Bearbeitungsstation können beispielsweise vorgegebene Einzelteile auf ein Grundelement montiert beziehungsweise vorgegebene elektronische Bauelemente auf eine Leiterplatte aufgebracht werden. Nach Durchlaufen aller Bearbeitungsstationen ist das Gerät in der Regel fertig montiert beziehungsweise die Leiterplatte vollständig bestückt und gegebenenfalls verlötet.

Der Transport des Grundelements beziehungsweise der Leiterplatte durch die Vorrichtung erfolgt regelmäßig mittels eines Transportbandes. Häufig verwendet man statt eines durchgehenden entsprechend langen Transportbandes eine Vielzahl kürzerer Transportbänder, die so hintereinander angeordnet sind, dass das Grundelement beziehungsweise die Leiterplatte ohne weiteres von einem Transportband auf das andere übergeben werden können. So kann sich beispielsweise ein Transportband lediglich durch eine Bearbeitungsstation erstrecken und die Verbindung von zwei Bearbeitungsstationen mittels eines anderen Transportbandes vorgenommen werden. Allen bekannten Ausführungsformen gemein ist, dass der reguläre Transportweg nicht verlassen werden kann.

Statt dass in den Bearbeitungsstationen unterschiedliche Bearbeitungsschritte durchgeführt werden, könnten in den Bearbeitungsstationen auch dieselben Arbeitsschritte durchgeführt werden, sodass die Bearbeitung der Werkstücke beziehungsweise die Bestückung der Leiterplatten in den Bearbeitungsstationen parallel erfolgt. Hierdurch vergrößert sich die Leistung der Vorrichtung.

Nachteilig bei der bekannten Vorrichtung ist, dass sie eine geringe Fehlertoleranz besitzt. So wirken sich Probleme in einer Bearbeitungsstation, die dazu führen, dass das Grundelement beziehungsweise die Leiterplatte nicht weiter transportiert werden kann, auf die gesamte Vorrichtung aus. Zum Beispiel führt bei der Bestückung von Leiterplatten das Fehlen eines bestimmten Bauteils in einer Station dazu, dass die gesamte Vorrichtung stoppt. Die Vorrichtung kann ihren Betrieb erst dann wieder aufnehmen, wenn der Vorratsbehälter für das fehlende Bauteil wieder aufgefüllt wurde.

Es ist Aufgabe der Erfindung eine Eingangs genannte Vorrichtung derart auszubilden, dass sie eine größere Fehlertoleranz besitzt.

Die Lösung dieser Aufgabe ergibt sich aus den Merkmalen des kennzeichnenden Teils des Anspruchs 1. Vorteilhafte Weiterbildungen der Erfindung ergeben sich aus den Unteransprüchen.

Gemäß der Erfindung ist eine Vorrichtung zum Bearbeiten von Werkstücken, insbesondere zum Bestücken von Leiterplatten, mit wenigstens zwei Bearbeitungsstationen, in welche die Werkstücke einbringbar sind und welche auf dem regulären Transportweg, auf dem die Werkstücke durch die Vorrichtung transportierbar sind, hintereinander angeordnet sind, dadurch gekennzeichnet, dass wenigstens ein erstes Bypasselement vorhanden ist, welches außerhalb des regulären Transportweges der Werkstücke angeordnet ist, und mittels dem die Werkstücke wenigstens an der ersten Bearbeitungsstation vorbeiführbar sind.

Dadurch, dass wenigstens ein außerhalb des regulären Transportweges der Werkstücke angeordnetes erstes Bypasssystem vorhanden ist, mittels dem die Werkstücke wenigstens an der ersten Bearbeitungsstation vorbeiführbar sind, kann ein betreffendes Werkstück im Bedarfsfall um die erste Bearbeitungsstation herum geleitet werden. Das heißt, wenn an der ersten Bearbeitungsstation eine Störung auftritt, die bewirkt, dass das Werkstück in der ersten Bearbeitungsstation nicht vollständig bearbeitet werden kann und somit nicht aus der ersten Bearbeitungsstation heraus geführt werden kann, kann das nachfolgende Werkstück unter Umgehung der ersten Bearbeitungsstation der zweiten Bearbeitungsstation zugeführt werden. Dies ist insbesondere dann zweckmäßig, wenn in beiden Bearbeitungsstationen dieselbe Bearbeitung des Werkstücks erfolgt. Somit können in der Vorrichtung trotz der Störung in der ersten Bearbeitungsstation weiterhin Werkstücke bearbeitet werden.

Sehr vorteilhaft ist auch eine Ausführungsform der Erfindung, bei der ein außerhalb des regulären Transportweges der Werkstücke angeordnetes zweites Bypasselement vorhanden ist, mittels dem die Werkstücke an der zweiten Bearbeitungsstation vorbeiführbar sind. Hierdurch können bei einer Störung der zweiten Bearbeitungsstation, die bewirkt, dass das Werkstück in der zweiten Bearbeitungsstation nicht vollständig bearbeitet werden kann und somit nicht aus der zweiten Bearbeitungsstation heraus geführt werden kann, ein in der ersten Bearbeitungsstation vollständig bearbeitetes Werkstück unter Umgehung der zweiten Bearbeitungsstation aus der Vorrichtung herausgeführt werden.

Besonders vorteilhaft ist eine Ausführungsform der Erfindung, bei der die Transportrichtung wenigstens des ersten Bypasselements umkehrbar ist. Hierdurch ist es möglich, ein Werkstück, welches beispielsweise in der ersten Bearbeitungsstation nicht ordnungsgemäß bearbeitet werden konnte, zum Eingang der ersten Bearbeitungsstation zurück zu führen, so dass es erneut in die erste Bearbeitungsstation eingebracht und dort die Bearbeitung erneut durchgeführt beziehungsweise fertig gestellt werden kann.

In vorteilhafter Weise ist auch die Transportrichtung des zweiten Bypasselements umkehrbar. Hierdurch kann das Werkstück die zweite Bearbeitungsstation auf seinem regulären Weg verlassen und kann, sofern erforderlich, zum Eingang der zweiten Bearbeitungsstation geführt werden. Insbesondere kann das Werkstück an den Eingang der ersten Bearbeitungsstation zurückgeführt werden. Hierzu wird das Werkstück auch über das erste Bypasselement zurückgeleitet.

Bei einer weiteren besonderen Ausführungsform der Erfindung ist ein erstes Transportelement vorhanden, mittels dem Werkstücke wenigstens der ersten Bearbeitungsstation zuführbar sind, sowie ein mittleres Transportelement vorhanden, in welches Werkstücke wenigstens von der ersten Bearbeitungsstation einleitbar sind, wobei das erste Transportelement derart verstellbar ist, dass Werkstücke dem ersten Bypasselement zuführbar sind, und das mittlere Transportelement derart verstellbar ist, dass von ihm Werkstücke aus dem ersten Bypasselement aufnehmbar sind.

Mittels des ersten Transportelements können der ersten Bearbeitungsstation somit Werkstücke auf dem regulären Transportweg zugeführt werden. Das heißt, der Ausgang des ersten Transportelements steht dem Eingang der ersten Bearbeitungsstation gegenüber. Nach Verstellung des ersten Transportelements steht der Ausgang des ersten Transportelements jedoch dem Eingang des ersten Bypasselements gegenüber, sodass ein sich im ersten Transportelement befindliches Werkstück an das erste Bypasselement übergeben werden kann.

Mittels des mittleren Transportelements können Werkstücke der ersten Bearbeitungsstation auf dem regulären Transportweg entnommen werden. Das heißt, der Eingang des mittleren Transportelements steht dann dem Ausgang der ersten Bearbeitungsstation gegenüber. Nach Verstellung des mittleren Transportelements steht der Eingang des mittleren Transportelements jedoch dem Ausgang des ersten Bypasselements gegenüber, sodass ein sich im ersten Bypasselement befindliches Werkstück an das mittlere Transportelement übergeben werden kann.

Entsprechend der vorstehend beschriebenen Ausführungsform der Erfindung kann sich bei einer weiteren Ausführungsform der Erfindung die zweite Bearbeitungsstation in einer ähnlichen Anordnung befinden. Hierbei sind mittels des mittleren Transportelements Werkstücke wenigstens der zweiten Bearbeitungsstation zuführbar. Des Weiteren ist wenigstens ein drittes Transportelement vorhanden, in welches Werkstücke wenigstens von der zweiten Bearbeitungsstation einleitbar sind, wobei das mittlere Transportelement derart verstellbar ist, dass Werkstücke dem zweiten Bypasselement zuführbar sind, und das dritte Transportelement derart verstellbar ist, dass von ihm Werkstücke aus dem zweiten Bypasselement aufnehmbar sind.

Mittels des mittleren Transportelements können somit der zweiten Bearbeitungsstation Werkstücke auf dem regulären Transportweg zugeführt werden. Das heißt, der Ausgang des mittleren Transportelements steht dem Eingang der zweiten Bearbeitungsstation gegenüber. Nach Verstellung des mittleren Transportelements steht der Ausgang des mittleren Transportelements jedoch dem Eingang des zweiten Bypasselements gegenüber, sodass ein sich im mittleren Transportelement befindliches Werkstück an das zweite Bypasselement übergeben werden kann.

Statt eines einzigen mittleren Transportelements können zwischen der ersten Bearbeitungsstation und der zweiten Bearbeitungsstation ein erstes und ein vom ersten getrenntes zweites Transportteilelement angeordnet sein. Die Werkstücke müssen dann beim Transport von dem ersten Transportteilelement an das zweite Transportteilelement übergeben werden.

Bei einer weiteren besonderen Ausführungsform der Erfindung ist vorgesehen, dass wenigstens ein erstes Pufferelement vorhanden ist, welches außerhalb des regulären Transportweges der Werkstücke angeordnet ist, und das erste Transportelement derart verstellbar ist, dass Werkstücke dem ersten Pufferelement zuführbar sind, und das mittlere Transportelement beziehungsweise das erste Transportelement derart verstellbar ist, dass von ihm Werkstücke aus dem ersten Pufferelement aufnehmbar sind.

Mittels des ersten Pufferelements können Werkstücke zwischengespeichert werden. Dies hat den Vorteil, dass Werkstücke, die zur ersten Bearbeitungsstation zurückgeführt werden sollen, bereits dann zurückgeführt werden können, wenn die erste Bearbeitungsstation noch durch ein anderes Werkstück belegt ist. Das zurückzuführende Werkstück wird dann zunächst in dem ersten Pufferelement zwischengespeichert. Wenn dann die erste Bearbeitungsstation wieder zur Aufnahme eines Werkstücks bereit ist, kann das sich im ersten Pufferelement befindliche Werkstück in die erste Bearbeitungsstation eingebracht werden. Da das erste Pufferelement in unmittelbarer Nähe der ersten Bearbeitungsstation angeordnet sein kann, ist die Zeit zum Einbringen des Werkstücks in die erste Bearbeitungsstation sehr gering.

Entsprechend der vorstehend beschriebenen Ausführungsform der Erfindung ist bei einer weiteren Ausführungsform der Erfindung wenigstens ein zweites Pufferelement vorhanden, welches außerhalb des regulären Transportweges der Werkstücke angeordnet ist, wobei das mittlere Transportelement beziehungsweise das zweite Transportteilelement derart verstellbar ist, dass Werkstücke dem zweiten Pufferelement zuführbar sind, und das dritte Transportelement derart verstellbar ist, dass von ihm Werkstücke aus dem zweiten Pufferelement aufnehmbar sind.

Hierdurch lässt sich in unmittelbarer Nähe der zweiten Bearbeitungsstation ein Werkstück, welches der zweiten Bearbeitungsstation zugeführt werden soll, während der Zeit, während der die zweite Bearbeitungsstation noch durch ein anderes Werkstück belegt ist, zwischenspeichern. Verlässt das sich in der zweiten Bearbeitungsstation befindliche Werkstück dann die zweite Bearbeitungsstation, kann das sich im zweiten Pufferelement befindliche Werkstück in sehr kurzer Zeit in die zweite Bearbeitungsstation eingebracht werden.

Bei einer weiteren besonderen Ausführungsform der Erfindung ist vorgesehen, dass wenigstens die erste Bearbeitungsstation sowie wenigstens das erste Pufferelement auf die Spurbreite der Werkstücke, insbesondere die Breite der Leiterplatten, einstellbar sind und die Einstellung der Spurbreite beziehungsweise der Leiterplattenbreite des ersten Pufferelements mit der Einstellung der Spurbreite beziehungsweise der Leiterplattenbreite der ersten Bearbeitungsstation gekoppelt ist. Hierdurch lassen sich auf einfache Weise Werkstücke beziehungsweise Leiterplatten in der ersten Bearbeitungsstation bearbeiten beziehungsweise bestücken, welche eine unterschiedliche Spurbreite beziehungsweise Leiterplattenbreite haben. Dies ist insbesondere dann vorteilhaft, wenn einzelne Werkstücke oder Leiterplatten oder kleine Serien von Werkstücken bearbeitet werden sollen.

In ähnlicher Weise ist bei einer weiteren besonderen Ausführungsform der Erfindung vorgesehen, dass wenigstens die zweite Bearbeitungsstation sowie wenigstens das zweite Pufferelement auf die Spurbreite der Werkstücke, insbesondere die Breite der Leiterplatten, einstellbar sind und die Einstellung der Spurbreite beziehungsweise der Leiterplatten des zweiten Pufferelements mit der Einstellung der Spurbreite beziehungsweise der Leiterplattenbreite der zweiten Bearbeitungsstation gekoppelt ist. Hierdurch lassen sich auch in der zweiten Bearbeitungsstation auf einfache Weise Werkstücke bearbeiten beziehungsweise Leiterplatten bestücken, welche eine unterschiedliche Spurbreite beziehungsweise Leiterplattenbreite haben.

Mittels der erfindungsgemäßen Vorrichtung ist zum einen gewährleistet, dass auch dann Werkstücke bearbeitet beziehungsweise Leiterplatten bestückt werden können, wenn in einer Bearbeitungsstation Störungen auftreten. Zum anderen lassen sich auf einfache Weise Werkstücke mit unterschiedlicher Spurbreite bearbeiten beziehungsweise Leiterplatten mit unterschiedlicher Breite bestücken. Durch das einfache Einstellen der Spurbreite beziehungsweise Leiterplattenbreite lassen sich insbesondere mit der erfindungsgemäßen Vorrichtung sehr kleine Serien von Werkstücken beziehungsweise Leiterplatten bis hinab zu einzelnen Werkstücken beziehungsweise Leiterplatten bearbeiten.

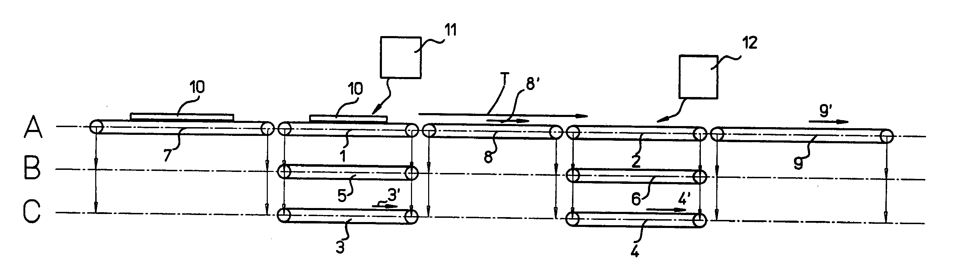

Weitere Einzelheiten, Merkmale und Vorteile der vorliegenden Erfindung ergeben sich aus der nachfolgenden Beschreibung eines besonderen Ausführungsbeispiels unter Bezugnahme auf die Zeichnung.

Es zeigt die einzige Figur eine schematische Darstellung einer erfindungsgemä-βen Vorrichtung.

Wie der Figur entnommen werden kann, weist eine erfindungsgemäße Vorrichtung eine erste Bearbeitungsstation 1 sowie eine zweite Bearbeitungsstation 2 auf. Die Bearbeitungsstationen 1, 2 sind schematisch als Transportbänder dargestellt, mittels der Leiterplatten 10, die auf den Transportbändern angeordnet sind, durch die Bearbeitungsstationen geführt werden. Die Leiterplatten 10 werden in den Bearbeitungsstationen 1, 2 mittels Bestückungsautomaten 11, 12 mit elektronischen Bauelementen bestückt. In der ersten Bearbeitungsstation 1 sowie in der zweiten Bearbeitungsstation 2 werden die Leiterplatten 10 jeweils mit denselben Bauelementen bestückt.

In Transportrichtung T der Leiterplatten 10 ist vor der ersten Bearbeitungsstation 1 ein erstes Transportelement 7, welches ebenfalls schematisch als Transportband dargestellt ist, angeordnet. In Transportrichtung T ist hinter der ersten Bearbeitungsstation 1 und vor der zweiten Bearbeitungsstation 2, welche ebenfalls schematisch als ein Transportband dargestellt ist, ein mittleres Transportelement 8, welches ebenfalls schematisch als ein Transportband dargestellt ist, angeordnet. Des Weiteren ist in Transportrichtung T hinter der zweiten Bearbeitungsstation 2 ein drittes Transportelement 9, welches ebenfalls schematisch als ein Transportband dargestellt ist, angeordnet. Alle Transportbänder 1, 2, 7, 8, 9 sind in der obersten Ebene A von drei Ebenen A, B, C angeordnet.

Das mittlere Transportelement 8 könnte durch zwei Transportteilelemente, welche unabhängig voneinander verstellbar sind, ersetzt werden. In gleicher Weise könnten auch die übrigen Transportbänder aus mehreren Teilbändern bestehen. Des Weiteren könnten hinter dem dritten Transportelement 9 noch weitere Transportelemente sowie weitere Bearbeitungsstationen angeordnet sein.

Das erste Transportelement 7 ist derart ausgebildet, beziehungsweise angeordnet, dass es von der obersten Ebene A in die mittlere Ebene B oder in die unterste Ebene C verstellt werden kann. In gleicher Weise ist das mittlere Transportelement 8 sowie das-dritte Transportelement 9 ausgebildet. Auch das mittlere Transportelement 8 beziehungsweise gegebenenfalls die Transportteilelemente sowie das dritte Transportelement 9 lassen sich in die mittlere Ebene B beziehungsweise in die unterste Ebene C verstellen.

Unterhalb der ersten Bearbeitungsstation 1 ist in der mittleren Ebene B ein erstes Pufferelement 5, welches schematisch als Transportband dargestellt ist, angeordnet. In gleicher Weise ist unterhalb der zweiten Bearbeitungsstation 2 in der mittleren Ebene B ein zweites Pufferelement 6, welches ebenfalls schematisch als Transportband dargestellt ist, angeordnet. Unterhalb des ersten Pufferelements 5 ist in der untersten Ebene C ein erstes Bypasselement 3, welches ebenfalls schematisch als Transportband dargestellt ist, angeordnet. In gleicher Weise ist unterhalb des zweiten Pufferelements 6 in der untersten Ebene C ein zweites Bypasselement 4, welches ebenfalls schematisch als ein Transportband dargestellt ist, angeordnet.

Statt dass die Elemente 1, 2, 3, 4, 5, 6 untereinander angeordnet sind, können sie quer zur Transportrichtung T nebeneinander angeordnet sein, wobei das erste Transportelement 7, das mittlere Transportelement 8 und das dritte Transportelement 9 dann horizontal verstellbar ausgebildet sind.

Beim regulären Betrieb der Vorrichtung werden die Leiterplatten 10 am Eingang der Vorrichtung dem ersten Transportelement 7 zugeführt, welches sie an die erste Bearbeitungsstation 1 übergibt. In der ersten Bearbeitungsstation 1 werden die Leiterplatten 10 mit elektronischen Bauelementen bestückt. Nach ihrer Bestückung mit den Bauelementen werden die Leiterplatten 10 dann an das mittlere Transportelement übergeben.

Von dem mittleren Transportelement 8 werden die Leiterplatten 10 an die zweite Bearbeitungsstation 2 übergeben. Da die Leiterplatten 10 bereits in der ersten Bearbeitungsstation 1 vollständig mit Bauelementen bestückt worden sind, werden sie ohne weitere Bearbeitung in der zweiten Bearbeitungsstation 2 an das vierte Transportelement 9 übergeben, welches die Leiterplatten 10 am Ausgang der Vorrichtung an ein der Vorrichtung nachgeschaltetes Element übergibt. Das der Vorrichtung nachgeschaltete Element ist in der Figur nicht dargestellt.

Der zuvor beschriebene Transportweg T der Leiterplatten 10 entspricht dem regulären Transportweg, auf dem die Werkstücke 10 regulär durch die Vorrichtung transportiert werden. Der reguläre Transportweg der Leiterplatten 10 durch die Vorrichtung verläuft somit in Transportrichtung T in der obersten Ebene A.

Sofern die Bestückung der Leiterplatten in beiden Bearbeitungsstationen 1, 2 gleich lange dauert, können die Leiterplatten 10 im selben Takt durch die Vorrichtung transportiert werden. Dauert die Bestückung der sich in der zweiten Bearbeitungsstation 2 befindlichen Leiterplatte beispielsweise aufgrund einer Störung länger als die Bestückung der sich in der ersten Bearbeitungsstation 1 befindlichen Leiterplatte so kann die sich in der ersten Bearbeitungsstation 1 befindliche Leiterplatte nach Fertigstellung der Bestückung dennoch an das mittlere Transportelement 8 übergeben werden, sodass die erste Bearbeitungsstation 1 zur Aufnahme einer unbestückten Leiterplatte bereit ist.

Nachdem sich die in der ersten Bearbeitungsstation 1 fertig bestückte Leiterplatte auf dem mittleren Transportelement 8 befindet, wird dieses so weit verstellt, bis es sich in der untersten Ebene C befindet. Gleichzeitig wird das vierte Transportelement 9 ebenfalls so weit abgesenkt, bis es sich in der untersten Ebene C befindet. Nachdem sich das mittlere Transportelement 8 und das vierte Transportelement 9 in der untersten Ebene C befinden, wird die fertig bestückte Leiterplatte von dem mittleren Transportelement 8 an das zweite Bypasselement 4 übergeben, welches die Leiterplatte dann unmittelbar an das vierte Transportelement 9 übergibt.

Nachdem sich die Leiterplatte auf dem vierten Transportelement 9 befindet, wird dieses verstellt, bis es sich wieder in der obersten Ebene A befindet. Dann kann die fertig bestückte Leiterplatte aus der Vorrichtung herausgeführt werden. Mittels der erfindungsgemäßen Vorrichtung ist es somit möglich, Leiterplatten auch dann zu bestücken, wenn die zweite Bearbeitungsstation 2 eine Störung aufweist.

Sollten die Leiterplatten 10 in der ersten Bearbeitungsstation 1 nicht vollständig mit den betreffenden Bauelementen bestückt werden können, weil beispielsweise betreffende Bauelemente im ersten Bestückungsautomaten 11 nicht mehr vorrätig sind, können die betreffenden Leiterplatten 10 nach ihrer teilweisen Bestückung in der ersten Bearbeitungsstation 1 an das mittlere Transportelement 8 übergeben werden. Von dem mittleren Transportelement 8 werden die betreffenden Leiterplatten 10 dann an die zweite Bearbeitungsstation 2 übergeben, in der sie mit den fehlenden Bauelementen bestückt werden können. Nach ihrer Bestückung mit den restlichen Bauelementen werden die Leiterplatten dann an das dritte Transportelement 9 übergeben, mittels dem es aus der Vorrichtung herausgeführt wird.

Da die Bestückung der Leiterplatten 10 mit den restlichen Bauelementen in der zweiten Bearbeitungsstation 2 in deutlich kürzerer Zeit erfolgt, als die Bestückung der unbestückten Leiterplatten 10 in der ersten Bearbeitungsstation 1, ergäbe sich bei der zweiten Bearbeitungsstation 2 eine Stillstandzeit. Dies wäre nachteilig. Daher können der zweiten Bearbeitungsstation 2 unter Umgehung der ersten Bearbeitungsstation 1 über das erste Bypasselement 3 Leiterplatten 10 zugeführt werden.

Hierzu wird das erste Transportelement 7 in die unterste Ebene C abgesenkt sodass eine sich auf dem ersten Transportelement 7 befindliche Leiterplatte 10 an das erste Bypasselement 3 übergeben werden kann. Gleichzeitig mit der Absenkung des ersten Transportelements 7 wird das mittlere Transportelement 8 in die unterste Ebene 10 abgesenkt, sodass die Leiterplatte 10 unmittelbar von dem ersten Bypasselement 3 an das dritte Transportelement 8 übergeben werden kann.

Nachdem sich die Leiterplatte 10 auf dem mittleren Transportelement 8 befindet, wird dieses wieder in die oberste Ebene A verstellt, sodass die Leiterplatte 10 von dem mittleren Transportelement 8 an die zweite Bearbeitungsstation 2 übergeben werden kann. Dort wird sie mit Bauelementen bestückt und nach Ihrer Bestückung an das dritte Transportelement 9 übergeben.

Sofern eine Leiterplatte 10 zur Vervollständigung ihrer Bestückung mit Bauelementen von der ersten Bearbeitungsstation 1 an die zweite Bearbeitungsstation 2 übergeben werden muss, die zweite Bearbeitungsstation 2 jedoch noch nicht zur Aufnahme der betreffenden Leiterplatte 10 bereit ist, da sie noch mit der Bestückung einer sich in ihr befindlichen Leiterplatte 10 beschäftigt ist, kann die noch nicht vollständig bestückte Leiterplatte 10 von der ersten Bearbeitungsstation 1 über das mittlere Transportelement 8 zunächst an das zweite Pufferelement 6 übergeben werden. Hierdurch wird die erste Bearbeitungsstation 1 in die Lage versetzt, mit der Bestückung einer noch unbestückten Leiterplatte 10 zu beginnen.

In gleicher Weise, wie in der zweiten Bearbeitungsstation 2 eine Leiterplatte 10 mit Bauelementen bestückt werden kann, mit denen sie in der ersten Bearbeitungsstation nicht bestückt werden konnte, können Leiterplatten 10 in der ersten Bearbeitungsstation 1 mit Bauelementen bestückt werden, mit denen sie in der zweiten Bearbeitungsstation 2 nicht bestückt werden konnten. Hierzu werden die betreffenden Leiterplatten 10 von der zweiten Bearbeitungsstation 2 beispielsweise an das dritte Transportelement 9 übergeben, welches nach Erhalt einer betreffenden Leiterplatte 10 in die unterste Ebene C abgesenkt wird. Nach der Absenkung des dritten Transportelements 9 in die unterste Ebene C wird mittels Umkehrung der regulären Bewegungsrichtung 9' des dritten Transportelements 9 sowie der regulären Bewegungsrichtung 4' des zweiten Bypasselementes 4 die betreffende Leiterplatte 10 von dem dritten Transportelement 9 an das zweite Bypasselement 4 übergeben.

In entsprechender Weise gelangt die betreffende Leiterplatte 10 dann über das mittlere Transportelement 8, welches gleichzeitig mit der Absenkung des dritten Transportelements 9 in die unterste Ebene C abgesenkt wurde, sowie das erste Bypasselement 3 auf das erste Transportelement 7, von dem sie der ersten Bearbeitungsstation 1 zugeführt werden kann. Es versteht sich von selbst, dass die Bewegungsrichtungen 8', 3' des mittleren Transportelements 8 und des ersten Bypasselements 3 ebenfalls umgekehrt werden müssen.

Auch bei der Zurückführung von Leiterplatten 10 an die erste Bearbeitungsstation 1 ist es möglich, eine betreffende Leiterplatte 10 in dem ersten Pufferelement 5 zwischenzuspeichern, sodass die Zurückführung der betreffenden Leiterplatte 10 teilweise bereits dann vorgenommen werden kann, wenn die erste Bearbeitungsstation 1 noch nicht zur Aufnahme einer Leiterplatte 10 bereit ist.

Mittels der erfindungsgemäßen Vorrichtung ist es somit möglich, auch dann Leiterplatten zu bestücken, wenn eine Bearbeitungsstation gestört ist. Dadurch, dass die Leiterplatten verschiedene Wege durch die Vorrichtung nehmen können, lassen sich in einer Bearbeitungsstation unvollständig bestückte Leiterplatten in der anderen Bearbeitungsstation fertig bestücken. Dies wirkt sich vorteilhaft auf die Ausgangsleistung der Vorrichtung aus.

Eine weitere Verbesserung der Ausgangsleistung der Vorrichtung wird dadurch erreicht, dass die Leiterplatten in unmittelbarer Nähe der Bearbeitungsstationen zwischengespeichert werden können. Denn hierdurch können die Leiterplatten bereits dann transportiert werden, wenn sie von der betreffenden Bearbeitungsstation noch nicht aufgenommen werden können. Der verbleibende Restweg der Leiterplatte von dem betreffenden Pufferspeicher ist kurz und kann daher in kurzer Zeit zurück gelegt werden.

Die Spurbreite der Bearbeitungsstationen 1, 2, der Transportelemente 7, 8, 9, der Bypasselemente 3, 4 sowie der Pufferelemente 5, 6 lässt sich verstellen. Hierdurch lassen sich auf einfache Weise unterschiedliche Leiterplatten in der Vorrichtung bestücken. Es ist somit möglich, sehr kleine Serien von Leiterplatten bis hinab zu einzelnen Leiterplatten in der Vorrichtung zu bestücken.

## Patentansprüche

1. Vorrichtung zum Bearbeiten von Werkstücken (10), insbesondere zum Bestücken von Leiterplatten, mit wenigstens zwei Bearbeitungsstationen (1, 2), in welche die Werkstücke (10) einbringbar sind, die auf einem Transportweg, auf dem die Werkstücke (10) regulär durch die Vorrichtung transportiert werden, hintereinander angeordnet sind,
**dadurch gekennzeichnet,**
**dass** wenigstens ein erstes Bypasselement (3) vorhanden ist, welches au-βerhalb des regulären Transportweges der Werkstücke (10) angeordnet ist, und mittels dem die Werkstücke (10) wenigstens an der ersten Bearbeitungsstation (1) vorbeiführbar sind.

2. Vorrichtung nach Anspruch 1,
**dadurch gekennzeichnet,**
**dass** ein zweites Bypasselement (4) vorhanden ist, welches außerhalb des regulären Transportweges der Werkstücke (10) angeordnet ist, und mittels dem die Werkstücke (10) an der zweiten Bearbeitungsstation (2) vorbeiführbar sind.

3. Vorrichtung nach Anspruch 1 oder 2,
**dadurch gekennzeichnet,**
**dass** die Transportrichtung (3') wenigstens des ersten Bypasselements (3) umkehrbar ist.

4. Vorrichtung nach einem der Ansprüche 1 bis 3,
**dadurch gekennzeichnet,**
**dass** die Transportrichtung (4') des zweiten Bypasselements (4) umkehrbar ist.

5. Vorrichtung nach einem der Ansprüche 1 bis 4,
**dadurch gekennzeichnet,**
**dass** wenigstens ein erstes Transportelement (7) vorhanden ist, mittels dem Werkstücke (10) wenigstens der ersten Bearbeitungsstation (1) zuführbar sind, sowie ein mittleres Transportelement (8) vorhanden ist, in welches Werkstücke (10) wenigstens von der ersten Bearbeitungsstation (1) einleitbar sind, wobei das mittlere Transportelement (8) als ein erstes und ein vom ersten getrenntes zweites Transportteilelement ausgebildet sein kann, und wobei das erste Transportelement (7) derart verstellbar ist, dass Werkstücke (10) dem ersten Bypasselement (3) zuführbar sind, und das mittlere Transportelement (7) beziehungsweise das erste Transportteilelement derart verstellbar ist, dass von ihm Werkstücke (10) aus dem ersten Bypasselement (3) aufnehmbar sind.

6. Vorrichtung nach einem der Ansprüche 1 bis 5,
**dadurch gekennzeichnet,**
**dass** mittels des mittleren Transportelements (7) beziehungsweise des zweiten Transportteilelements Werkstücke (10) wenigstens der zweiten Bearbeitungsstation (2) zuführbar sind, sowie wenigstens ein drittes Transportelement (9) vorhanden ist, in welches Werkstücke (10) wenigstens von der zweiten Bearbeitungsstation (2) einleitbar sind, wobei das mittlere Transportelement (8) beziehungsweise das zweite Transportteilelement derart verstellbar ist, dass Werkstücke (10) dem zweiten Bypasselement (4) zuführbar sind, und das dritte Transportelement (9) derart verstellbar ist, dass von ihm Werkstücke (10) aus dem zweiten Bypasselement (4) aufnehmbar sind.

7. Vorrichtung nach einem der Ansprüche 1 bis 6,
**dadurch gekennzeichnet,**
**dass** wenigstens ein erstes Pufferelement (5) vorhanden ist, welches au-βerhalb des regulären Transportweges der Werkstücke (10) angeordnet ist, und das erste Transportelement (7) derart verstellbar ist, dass Werkstücke (10) dem ersten Pufferelement (5) zuführbar sind, und das mittlere Transportelement (8) beziehungsweise das erste Transportteilelement derart verstellbar ist, dass von ihm Werkstücke (10) aus dem ersten Pufferelement (5) aufnehmbar sind.

8. Vorrichtung nach einem der Ansprüche 1 bis 7,
**dadurch gekennzeichnet,**
**dass** wenigstens ein zweites Pufferelement (6) vorhanden ist, welches au-βerhalb des regulären Transportweges der Werkstücke (10) angeordnet ist, und das mittlere Transportelement (8) beziehungsweise das zweite Transportteilelement derart verstellbar ist, dass Werkstücke (10) dem zweiten Pufferelement (6) zuführbar sind, und das dritte Transportelement (9) derart verstellbar ist, dass von ihm Werkstücke (10) aus dem zweiten Pufferelement (6) aufnehmbar sind.

9. Vorrichtung nach einem der Ansprüche 5 bis 8,
**dadurch gekennzeichnet,**
**dass** wenigstens die erste Bearbeitungsstation (1) sowie wenigstens das erste Pufferelement (5) auf die Spurbreite der Werkstücke (10) einstellbar sind und die Einstellung der Spurbreite des ersten Pufferelements (5) mit der Einstellung der Spurbreite der ersten Bearbeitungsstation (1) gekoppelt ist.

10. Vorrichtung nach einem der Ansprüche 5 bis 9,
**dadurch gekennzeichnet,**
**dass** wenigstens die zweite Bearbeitungsstation (2) sowie wenigstens das zweite Pufferelement (6) auf die Spurbreite der Werkstücke (10) einstellbar sind und die Einstellung der Spurbreite des zweiten Pufferelements (6) mit der Einstellung der Spurbreite der zweiten Bearbeitungsstation (2) gekoppelt ist.
